Europäisches Patentamt

European Patent Office

Office européen des brevets

(19)

(11) Publication number: **0 194 652**

**A1**

(12) # EUROPEAN PATENT APPLICATION

(21) Application number: **86103258.9**

(22) Date of filing: **11.03.86**

(51) Int. Cl.⁴: **C 23 C 14/06**
**C 23 C 14/24, C 23 C 14/58**
**G 01 N 1/06**

(30) Priority: **13.03.85 JP 49545/85**

(43) Date of publication of application:
**17.09.86 Bulletin 86/38**

(84) Designated Contracting States:
**CH DE LI SE**

(71) Applicant: **Shin-Etsu Chemical Co., Ltd.**
**6-1, Ohtemachi 2-chome**
**Chiyoda-ku Tokyo 100(JP)**

(72) Inventor: **Kitamura, Hajime**
**6-14-12, Aobadai**
**Ichihara-shi Chiba-ken(JP)**

(72) Inventor: **Iida, Tamaki 1-202, Hanakoganei-Green Hights**
**3-8-43, Minami-cho**
**Higashikurume-shi Tokyo(JP)**

(74) Representative: **Jaeger, Klaus, Dr. et al,**
**JAEGER & PARTNER Patentanwälte Bergstrasse 48 1/2**
**D-8035 München-Gauting(DE)**

(54) Coated blade for microtome and method for the preparation thereof.

(57) A microtome blade made of, for example, sapphire is imparted with greatly improved cutting power as well as durability and anti-corrosion resistance by providing a coating layer of crystalline silicon carbide thereon. Such a coating layer can be formed by subjecting a base blade to a treatment of plasma-induced chemical vapor deposition of amorphous silicon carbide in an atmosphere of an organosilane compound such as tetramethyl disilane followed by a heat treatment at 700-1250°C to convert the amorphous silicon carbide into a crystalline form.

EP 0 194 652 A1

## COATED BLADE FOR MICROTOME AND METHOD FOR
## THE PREPARATION THEREOF

### BACKGROUND OF THE INVENTION

The present invention relates to a coated blade for microtome or, more particularly, to a coated blade for microtome having markedly improved durability, anti-corrosion resistance and cutting power and a method for the preparation thereof.

Along with the progress in the medical and biological sciences in recent years, the importance of microscopic investigations is increasing more and more and many fine results are obtained as a consequence of the improvements in the performance of optical and electron microscopes and in related techniques. Needless to say, microscopic study of medical and biological materials is performed in many cases with a specimen of an extremely thin sliced section of the living body tissue prepared by use of a microtome. Various materials are used for the preparation of blades mounted on a microtome for such a purpose including metals, glass, sapphire and diamond. Microtome blades prepared of these materials and used as such have their respective disadvantages and problems. For example, metal-made microtome blades must have the edge redressed after each time of their use. Glass-made microtome blades are usually throwaway or disposable and any blade once used must be replaced with a new one

0194652

having an acutely angled edge newly formed by breaking a glass plate at the sacrifice of the efficiency of the microscopic examination works. Sapphire-made microtome blades have relatively poor cutting power and durability for their expensiveness in comparison with metal- and glass-made blades. Diamond blades are very expensive because they are manufactured by handicraft with low productivity.

In addition, some of the conventional microtome blades have a problem that striation or chatter marks appear on the sliced specimen therewith so that they are not always suitable for use in high-grade investigations of medical and biological sciences. While it is not rare that the microscopic examination in the fields of recent medical and biological sciences requires an extremely thin sliced specimen having a thickness of 50 nm or smaller, in particular, such a thin specimen can hardly be prepared by use of conventional microtome blades.

## SUMMARY OF THE INVENTION

The present invention therefore has an object to provide a blade for microtome free from the above described problems and disadvantages in the conventional microtome blades.

The microtome blade of the present invention is a blade having a specific coating layer on a base blade. Namely, the blade for microtome of the invention comprises:

(a)   a base blade; and

(b)   a coating layer of crystalline silicon carbide formed
      on the base blade.

The coated microtome blade mentioned above can be prepared by subjecting a base blade of glass, metal or ceramic
to a treatment of plasma-induced vapor-phase deposition in
an atmosphere of an organosilane compound to form a layer of
amorphous silicon carbide deposited on the surface of the
base blade and then subjecting the blade coated with the
layer of amorphous silicon carbide to a heat treatment so as
to convert the amorphous silicon carbide into a crystalline
form.

It is also proposed that the cutting performance of the
thus coated microtome blade can be further improved by providing an extremely thin coating film of olive oil or oleic
acid thereon.

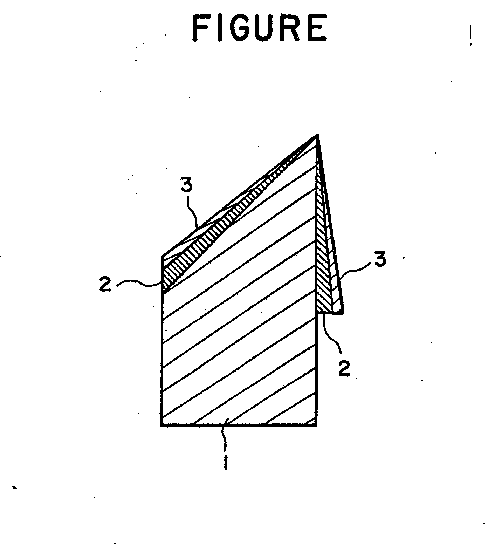

## BRIEF DESCRIPTION OF THE DRAWING

The figure schematically illustrates a cross section of
the coated blade for microtome according to the invention.

## DETAILED DESCRIPTION OF THE PREFERRED EMBODIMENTS

As is described above, the microtome blade of the invention is characterized by the coating layer of crystalline silicon carbide formed on a substrate base blade and, by virtue of the wearing resistance, anti-corrosion resistance and extremely high hardness of the crystalline silicon carbide, the coated microtome blade of the invention is imparted with greatly improved durability, anti-corrosion resistance and cutting power in comparison with conventional microtome blades.

The base blade as the substrate of coating is not particularly limitative in respect of the material and may be made of any of the same materials as in conventional microtome blades including metallic materials such as stainless steel and hard metals, glass, sapphire and the like. The coating layer of crystalline silicon carbide formed on the base blade should have a thickness in the range from 5 nm to 50 nm since the reliability of the effect obtained by the coating would be low when the thickness of the coating layer is too small while a microtome blade provided with a coating layer having a thickness larger than 50 nm is not suitable for the preparation of an extremely thin sliced section for microscopic examination. The thickness of the coating layer should preferably be in the range from 8 nm to 20 nm.

The figure of the accompanying drawing illustrates the coated microtome blade by a cross section in a plane perpendicular to the edge of the blade, in which the base blade 1 is provided with a coating layer 2 of crystalline silicon carbide on both surfaces intersecting in the edge line. The base blade 1 made of a metal, glass, sapphire and the like material should have a sufficiently sharp edge making an acute angle. As is illustrated in the figure, the coating layer 2 of the crystalline silicon carbide should preferably have a smallest thickness on the edge with increasing thickness with the increase of the distance from the edge.

The above mentioned coating layer can be formed by several methods but a convenient method is to utilize the process of plasma-induced chemical vapor-phase deposition. Thus, the base blade is subjected to a treatment of plasma-induced chemical vapor-phase deposition in an atmosphere of an organosilane compound so as to deposit a thin layer of amorphous silicon carbide on the surface followed by a heat treatment to convert the amorphous silicon carbide into a crystalline form.

The plasma-induced chemical vapor-phase deposition of amorphous silicon carbide on a base blade is performed by placing the base blade in a plasma chamber and, while the pressure inside the plasma chamber is kept at 1 Torr or below by continuously introducing vapor of an organosilane compound together with a carrier gas such as hydrogen and argon, by generating plasma inside the plasma chamber with impression of a high-frequency electric power between the electrodes installed inside the chamber. The vapor of the organosilane compound is then decomposed in the plasma atmosphere and deposited as amorphous silicon carbide to form
a thin coating layer on the surface of the base blade. The
vapor-phase deposition is continued until the thickness of
the coating layer has reached a desired value.

The coating layer thus deposited is formed of amorphous
silicon carbide having a relatively low hardness so that it
is essential to convert the amorphous silicon carbide into a
crystalline form having an increased hardness by a heat
treatment of the coated blade at a temperature in the range
from 700 to 1250 °C.

Various kinds of organosilane compounds can be used in
the above described plasma-induced chemical vapor deposition
of amorphous silicon carbide including monomethyl silane
$MeSiH_3$, dimethyl silane $Me_2SiH_2$, trimethyl silane $Me_3SiH$ and
tetramethyl silane $Me_4Si$, in which Me denotes a methyl
group. In place of an organosilane compound, a mixture of
silane $SiH_4$ and a hydrocarbon compound can be used. More
preferably, however, the organosilane compound should be a
methyl hydrogen polysilane represented by the general for-
mula $Me_aSi_bH_c$, in which b is 2 or 3 and a and c are each a
positive integer with the proviso that $a+1 \leq 2b+1$,
$1 < c \leq 2b+1$ and $a+c = 2b+2$. Particular examples of the
methyl hydrogen polysilane include: 1,1,2,2-tetramethyl disilane; 1,2,2-trimethyl disilane; 1,2-dimethyl disilane;

monomethyl disilane; 1,1,2,2,3,3-hexamethyl trisilane; 1,1,2,3,3-pentamethyl trisilane; 1,1,3,3-tetramethyl trisilane; 1,2,3-trimethyl trisilane; 1,3-dimethyl trisilane; 2,2-dimethyl trisilane and the like. When vapor of these organosilane compounds is introduced into the atmosphere of plasma generated by the impression of a high-frequency electric power at a frequency of 1 to 30 MHz, the organosilane compound is readily decomposed to form silicon carbide which is deposited on the substrate surface in an amorphous state. The vapor of the organosilane compound is introduced into the plasma chamber as diluted with a carrier gas which is preferably hydrogen gas or argon. Any oxidizing gas should be excluded from the atmosphere of plasma in order to avoid possible oxidation of the once formed silicon carbide layer.

In order to ensure satisfactory cutting power of the coated microtome blade described above, it is a preferable condition that the angle of edge, i.e. the angle made by the two surfaces of the blade intersecting in the edge line, is in the range from 15° to 70° or, more preferably, from 30° to 50° since nicks are sometimes formed in the edge having an edge angle smaller than 15° while a blade having an edge angle larger than 70° has a greatly decreased cutting power.

When the above described microtome blade coated with a coating layer of crystalline silicon carbide was used for the preparation of an extremely thin sliced section of a

- 8 -     0194652

living body tissue for microscopic examination, it was found that the cutting power of the blade could further be improved by providing the blade with a very thin layer of olive oil or oleic acid. Such a microtome blade having an oleaginous coating film is illustrated in the figure of the accompanying drawing. Thus, the blade formed by providing a coating layer 2 of crystalline silicon carbide to the base blade 1 is further provided with an oleaginous overcoating film 3. The oleaginous coating film of olive oil or oleic acid can be formed by dipping the blade having a coating layer of crystalline silicon carbide after the heat treatment in olive oil or oleic acid. The blade should be dipped in the olive oil or oleic acid preferably as immediately as possible after the heat treatment but, in any case, after the temperature of the surface has dropped to 50 $^{\circ}$C or below. Dipping of the blade should be performed for at least 10 minutes or, preferably, for 40 to 80 minutes and the blade taken out of the olive oil or oleic acid should be washed with an organic solvent such as methyl alcohol, hexane, acetone, ethyl acetate and the like for 20 to 80 minutes or, preferably, 30 to 60 minutes. When the dipping time of the blade is shorter than 10 minutes, no complete film of the oleic acid or olive oil can be formed so that the sliced specimen prepared by use of the blade cannot be completely free from striation or chatter marks. When the time of washing with an organic solvent is shorter than 20 minutes, an extraneous amount of the olive oil or oleic acid is left on the blade so that a sliced specimen having a thickness of 50 nm or smaller can hardly be prepared using such a microtome blade. Extension of the washing time over 80 minutes is also undesirable due to the appearance of striation or chatter marks in the sliced specimen.

In the following, examples are given to illustrate the coated microtome blade of the invention as well as the method for the preparation thereof in more detail.

Example 1.

Synthetic sapphire was worked into a form of microtome blade followed by washing with deionized water and isopropyl alcohol and the thus prepared base blade was placed in a plasma chamber equipped inside with a pair of electrodes in such a disposition that the direction of the gas flow inside the chamber was in parallel with the bisector plane of the angle made by the two surfaces of the blade intersecting in the edge line.

The plasma chamber was then evacuated to have a reduced pressure of $5 \times 10^{-2}$ Torr and a gaseous mixture of tetramethyl disilane vapor and hydrogen gas was introduced into the chamber at such a rate that the gaseous pressure inside the chamber could be controlled at 0.1 Torr by the balance with continued evacuation. While keeping the atmospheric condition mentioned above, a high frequency electric power of 30 watts at a frequency of 13.56 MHz was impressed between the electrodes to generate plasma by the glow discharge so that the base blade was coated with a layer of amorphous silicon carbide having a thickness of 10 to 15 nm after 3 minutes of the plasma-induced chemical vapor deposition in the atmosphere of the disilane compound.

The thus coated base blade of synthetic sapphire taken out of the plasma chamber was washed and then subjected to a heat treatment at 1000 °C for 30 minutes in an inert atmosphere. No defects could be found on the thus prepared microtome blade by the inspection using an optical microscope. X-ray diffractometric examination of the coating layer indicated that the initially amorphous silicon carbide had been completely converted into a crystalline form.

The thus prepared coated microtome blade was used in a test of cutting to prepare a sliced specimen of an internal organ tissue fixed with an epoxy resin for microscopic examination to find that sliced specimens having a thickness of 50 nm could easily be obtained. The accuracy of the sliced specimen was as good as that of the specimen prepared by use of a diamond blade and the coated microtome blade of the invention had indeed much better durability, wearing resistance and cutting power than conventional microtome blades other than the diamond blades.

Example 2.

A base blade of synthetic sapphire having an edge angle
of 45° was provided with a coating layer of crystalline
silicon carbide in the same manner as in Example 1 and, after cooling from the temperature for the crystallization of
silicon carbide, the coated blade was dipped in oleic acid
for 60 minutes. The blade taken out of the oleic acid was
washed for 30 minutes in hexane and dried.

The thus obtained coated microtome blade was used in
the test of cutting in the same manner as in Example 1 to
find that the sliced specimen of the internal organ tissue
was even more satisfactory with still decreased striation
and chatter marks by the examination under 6000 magnification.

Example 3.

A base blade of synthetic sapphire having an edge angle
of 60° was prvided with a coating layer of crystalline silicon carbide in the same manner as in Example 1 and, when the
temperature of the blade under cooling had reached 50 °C,
immediately dipped in olive oil to be kept therein for 60
minutes. The blade taken out of the olive oil was washed for
60 minutes with ethyl acetate and dried.

The thus coated and oil-treated microtome blade was
used in the test of cutting in the same manner as in Example

to find that the sliced specimen of the internal organ
tissue was even more satisfactory with substantial absence
of striation and chatter marks by the examination under 6000
magnification.

WHAT IS CLAIMED IS:

1.    A microtome blade which comprises:  (a) a base blade; and (b) a coating layer of crystalline silicon carbide formed on the surface of the base blade.

2.    The microtome blade as claimed in claim 1 wherein the coating layer of crystalline silicon carbide has a thickness in the range from 5 to 50 nm.

3.    The microtome blade as claimed in claim 1 which is further provided with a thin film of olive oil or oleic acid.

4.    A method for the preparation of a microtome blade coated with a layer of crystalline silicon carbide which comprises the steps of:
(a)  subjecting a base blade to a treatment of plasma-induced chemical vapor deposition of amorphous silicon carbide by exposing the same to an atmosphere of plasma generated in a vapor of an organosilane compound; and
(b)  subjecting the base blade thus coated with a layer of amorphous silicon carbide to a heat treatment at a temperature in the range from 700 to 1250 $^{\circ}$C so as to convert the amorphous silicon carbide into a crystalline form.

5.    The method for the preparation of a microtome blade as claimed in claim 4 wherein the organosilane compound is a methyl hydrogen polysilane represented by the general formula $(CH_3)_aSi_bH_c$, in which b is 2 or 3 and a and c are each a positive integer with the proviso that $a+1 \leq 2b+1$, $1 < c \leq 2b+1$ and $a+c = 2b+2$.

6.    The method for the preparation of a microtome blade as claimed in claim 4 wherein the step (b) is succeeded by a step (c) in which the microtome blade coated with a layer of crystalline silicon carbide is dipped in olive oil or oleic acid followed by washing with an organic solvent.

7.    The method for the preparation of a microtome blade as claimed in claim 6 wherein the microtome blade coated with a layer of crystalline silicon carbide is dipped in olive oil or oleic acid for a length of time of at least 10 minutes.

8.    The method for the preparation of a microtome blade as claimed in claim 5 wherein the microtome blade after dipping in olive oil or oleic acid is washed with an organic solvent for a length of time in the range from 20 to 80 minutes.

1/1

# FIGURE

European Patent Office

EUROPEAN SEARCH REPORT

0194652
Application number

## DOCUMENTS CONSIDERED TO BE RELEVANT

EP 86103258.9

| Category | Citation of document with indication, where appropriate, of relevant passages | Relevant to claim | CLASSIFICATION OF THE APPLICATION (Int. Cl.4) |
|---|---|---|---|
| A | <u>GB - A - 1 109 123</u> (RADIO CORPORA-TION OF AMERICA)<br><br>* Example 1 *<br><br>-- | 1-4 | C 23 C 14/06<br><br>C 23 C 14/24<br><br>C 23 C 14/58<br><br>G 01 N 1/06 |
| A | <u>US - A - 4 426 405</u> (F.J. HIERHOLZER JR. et al.)<br><br>* Claims *<br><br>-- | 1-4 | |
| A | <u>US - A - 4 363 828</u> (M.H. BRODSKY et al.)<br><br>* Abstract; claims *<br><br>---- | 1-4 | |

TECHNICAL FIELDS SEARCHED (Int. Cl.4)

C 23 C

G 01 N

The present search report has been drawn up for all claims

| Place of search | Date of completion of the search | Examiner |
|---|---|---|
| VIENNA | 22-05-1986 | SLAMA |